# EUROPEAN PATENT APPLICATION

(11) **EP 2 224 469 A2**
(43) Date of publication of application: **01.09.2010**
(21) Application number: 10154439.3
(22) Date of filing: 23.02.2010
(51) Int. Cl.: H01L 21/304, H01L 21/3065, H01L 21/02

(54) **Method for etching 3d structures in a semiconductor substrate, including surface preparation**

(30) Priority: 25.02.2009 US 155426 P
(71) Applicant: IMEC, 3001 Leuven (BE)
(72) Inventor: Verdonck, Patrick, B-1970, Wezembeek-Oppem (BE); Van Cauwenberghe, Marc, B-9810, Nazareth (BE); Phommahaxay, Alain, B-3000, Leuven (BE); Cotrin Teixeira, Ricardo, 13081-030 Campinas, SP (BR); Tutunjyan, Nina, B-3000, Leuven (BE)
(74) Representative: pronovem

(57) **Abstract**

The present invention is related to method for producing 3D structures in a semiconductor substrate using Deep Reactive Ion Etching (DRIE), comprising at least the steps of:
- providing a substrate (1), and then
- grinding the backside of the substrate in order to achieve a thinned substrate, wherein extrusions (2) and native oxides (3) are left after said grinding step, and then
- performing a surface treatment selected from the group consisting of a wet etching step and a dry etching step in order to remove at least said native oxides (3) and extrusions (2) on the surface of said backside of the substrate which are causes for the grass formation during subsequent etching, and then
- performing deep reactive ion etching in order to achieve 3D vias.

## Description

### Field of the invention

The present invention is related to the field of semiconductor processing, in particular to the process known as Deep Reactive Ion Etching (DRIE), which is used to produce deep vias in a semiconductor (primarily Si) substrate. More particularly, the present invention is related to a surface treatment method after a grinding process step in order to avoid unwanted residuals which may lead to unwanted "grass formation" during the DRIE step.

### State of the art

Deep reactive ion etching (DRIE) of Si is one of the most important process steps for fabrication of different sensors and actuators and for 3D integration. For some applications, the deep Si etching has to be carried out on thinned substrates, i.e. a second Si wafer is bonded to a first processed wafer and after this bonding, the wafer is thinned. This thinning process often consists of a first rough grinding step followed by a second (finer) grinding step. For some applications, a still finer polish process referred to as the final thinning step using Chemical Mechanical Polishing (CMP) is applied. However, if possible, this is avoided for cost (process time) and yield reasons. When this final thinning step is omitted, the subsequent Deep Reactive Ion Etching (DRIE), directly performed on ground surfaces, will suffer from the fact that even the smallest roughness caused by the ultra fine grinding processes can lead to detrimental effects on the DRIE, especially through so-called "grass formation". Grass formation is characterized as spear-shaped Si residues that are not etched as they should be. On ground wafers, grass formation occurs after DRIE (e.g. during etching of a deep via). The only known way of avoiding the extrusions, is by applying CMP prior to the DRIE process.

### Aims of the invention

It is an object of the invention to provide an easy and cost friendly solution to avoid grass formation and an alternative to the costly and time consuming CMP step and thereby avoiding the problem of grass formation. More particularly, it is an object of the invention to remove the cause of the micro-masking without applying a CMP step.

### Summary of the invention

The invention is related to a method as disclosed in the appended claims. In particular, the invention is related to a method for producing 3D structures in a semiconductor substrate using Deep Reactive Ion Etching (DRIE), comprising at least the steps of:
- providing a substrate,
- grinding the backside of the substrate in order to achieve a thinned substrate, wherein extrusions and native oxides are left after said grinding step,
- performing a surface treatment selected from the group consisting of a wet etching step and a dry etching step in order to remove at least said native oxides and extrusions on the surface of said backside of the substrate which are causes for the grass formation during subsequent etching,
- performing deep reactive ion etching in order to achieve 3D vias.

The substrate may be a silicon wafer, more preferably a processed silicon wafer comprising active devices.

According to an embodiment, the surface treatment step is a wet etching step performed by immersion, spray or puddle etching of the substrate in a solution comprising HNO₃, HF and H₂O or acetic acid, where the HNO₃ (65% conc.) to HF (49% conc.) ratio is preferably in the range 3:1 to 1:2 and the H₂O and the acetic acid content is preferably at least the same of the other constituents. Said solution may consist of 1 part HNO₃ (65% conc.), 1part HF (49%) and 2 parts H₂O. The wet etching step may be performed during a time interval of between 15 seconds and 2 minutes.

According to another embodiment, the surface treatment step is a dry etching step performed using a CCP plasma or an ICP plasma. More particularly, the surface treatment step may be a dry etching step performed using an ICP or CCP plasma containing one or more fluorine containing gases (e.g. SF₆), with optionally one or more additive gases (e.g. Ar).

The surface treatment step may be a dry etching step performed using a CCP type reactor wherein the absolute value of the Bias voltage or of the LF component of the applied voltages is 200 V or higher. Also, the the surface treatment step may be a dry etching step performed using an ICP type reactor wherein the absolute value of the Bias voltage or of the LF component of the applied voltages, is 100 V or higher.

The invention is also related to the use of the method according to the invention in DRIE etching of deep silicon structures (e.g. vias) in 3D integration of silicon wafers.

It is an advantage of a method according to preferred embodiments that a supplementary time-consuming and expensive chemical mechanical polishing step after grinding can be avoided. It is a further advantage of the method according to preferred embodiments of the invention that no additional tool is needed and the surface treatment in order to prevent/avoid grass formation can be performed in the same (etch) chamber in which the subsequent DRIE etching of 3D structures is performed.

### Brief description of the figures

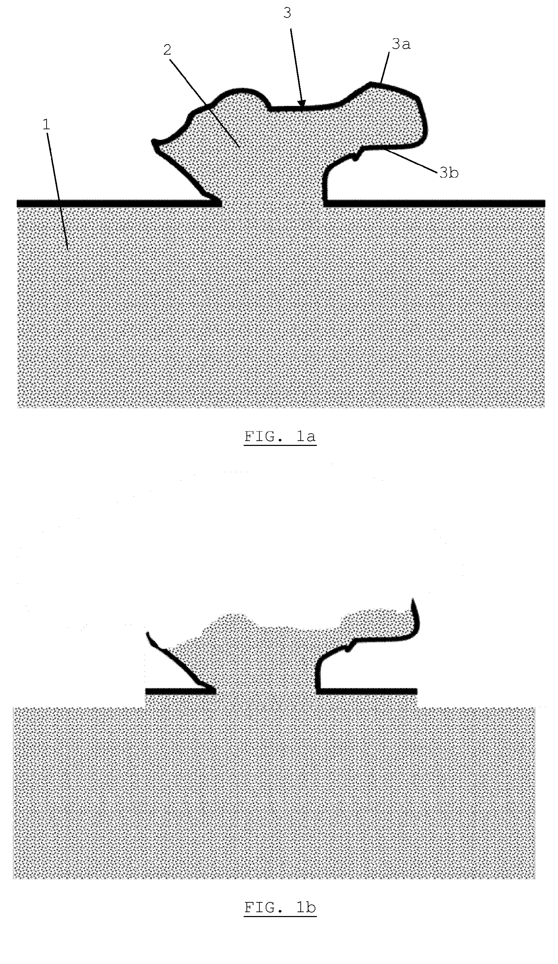

Figures 1a to 1d illustrate schematically how the grass formation takes place as a consequence of extrusions remaining on the surface after grinding.

### Detailed description of the invention

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Moreover, the term top and the like in the description and the claims are used for descriptive purposes and not necessarily for describing relative positions. It is to be understood that the terms so used are interchangeable under appropriate circumstances and that the preferred embodiments described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that preferred embodiments may be practiced without these specific details. In other instances, well-known methods, structures and techniques have not been shown in detail in order not to obscure an understanding of this description.

The term "ICP" as referred to in the claims and the description is used to define an inductively coupled plasma (ICP) and is referring to a type of plasma source in which the energy is supplied through a coil by radio frequent (typically 13.56 MHz) electrical currents which induce varying magnetic and electric fields, which deliver energy to the plasma. ICP may also be referred to as 'TCP', Transformer coupled plasma. An ICP/TCP reactor is thus equipped with an RF source coupled to a coil through which the plasma is created. An ICP/TCP reactor may further be equipped with an RF or an LF source coupled to an electrode (as in a CCP reactor, see hereafter).

The term "CCP" as referred to in the claims and the description is used to define a capacitive coupled plasma (CCP) and is referring to a type of plasma source where radio frequent electric tensions/voltages are transferred through a capacitor to the plasma. One of two electrodes is connected to the power supply. A CCP reactor is thus equipped with an RF power source (typically operating at 13.56MHz), coupled (through a capacitor) to one of the electrodes between which the plasma is created. Ions respond to the time-averaged potential over the capacitor, generally referred to as the DC-bias voltage (VDC) of the CCP reactor. A CCP reactor may also be equipped with a Low Frequency source (for example operating at 113kHz).

The invention will now be described by a detailed description of several preferred embodiments. It is clear that other preferred embodiments can be configured according to the knowledge of persons skilled in the art without departing from the true spirit or technical teaching of the invention as defined by the appended claims.

The root cause for the grass formation are Si-based extrusions originating from a not-perfectly polished surface. These extrusions hamper the DRIE etch, in such a way that sharp spikes are left on the surface after the DRIE process. The etch hampering mechanism is however not caused by the silicon extrusion itself because these will be readily etched but by the (unavoidable) formation of a native oxide around the extrusions (SiOₓ formation). These oxidized extrusions will act as a "micromask" during the subsequent dry etching process. The cause, being the oxidized surface of the Silicon extrusions leading towards SiOₓ micromasks, has not been recognized before in the state of the art.

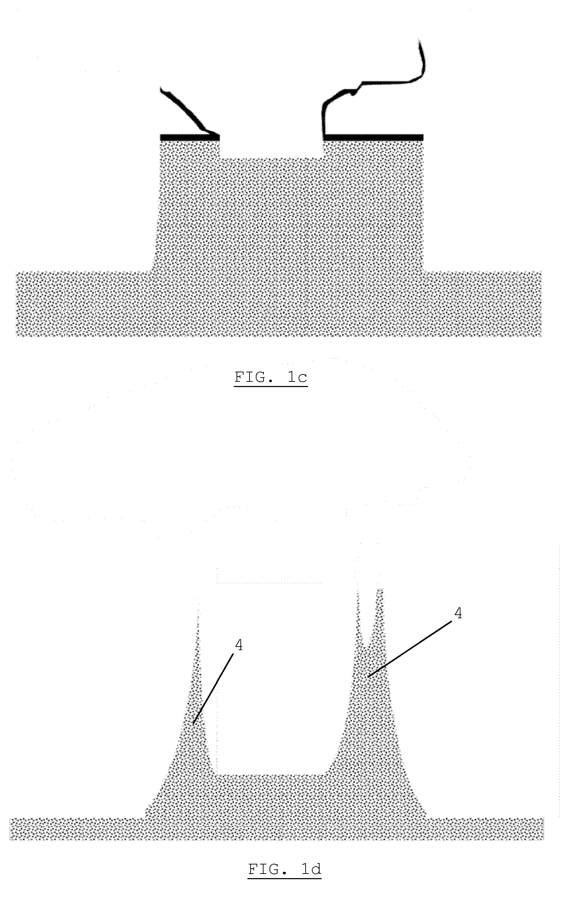

Figures 1a-1d illustrate the problem. A silicon substrate 1 is shown in figure 1a, with a Si-extrusion 2 on the surface, left after the grinding step. A SiOx layer 3 is formed on the outer surface of the extrusion. Figure 1b illustrates the result of the first stages of the DRIE process. Due to the higher selectivity of the process to SiOx, the oxide layer is etched slower than the surrounding Si. Moreover, it can be seen that an extrusion of the type shown in figure 1a represents two oxide layers 3a and 3b which need to be etched, due to the overhanging portion of the extrusion. This increases the difference in etching depth between the extrusion and the surrounding surface. The result, as illustrated in figures 1c and 1d, is the formation of spikes 4 when the DRIE process is finished.

The object of the invention is achieved by removing the oxidized surface of the extrusions using wet and/or dry etch processes. The above objective is accomplished by a method according to preferred embodiments described below.

According to preferred embodiments, the method comprises at least a pre-cleaning step which is performed to remove at least part of the residues responsible for the micro masking effect that lead to the grass formation issue. This cleaning step may consist of a wet etch step or a dry etch step or a combination of both.

According to preferred embodiments a method for avoiding grass formation after grinding and during reactive ion etching is provided. The method of the invention is thus a method for producing 3D structures in a semiconductor substrate using DRIE, said method comprising at least the steps of:
- providing a substrate,
- grinding the backside of the substrate in order to achieve a thinned substrate,
- performing a surface treatment selected from at least one of a wet etching step and a dry etching step in order to remove at least the native oxides and extrusions on the surface of the substrate which are causes for the grass formation during subsequent etching,
- performing deep reactive ion etching in order to achieve 3D structures.

According to preferred embodiments the substrate is a silicon wafer (semiconductor substrate). More preferably the substrate is a processed silicon wafer comprising active devices, on a front side. The substrate is preferably first bonded to a second substrate, before grinding the backside of the substrate.

According to preferred embodiments, the step of grinding the backside of the substrate comprises a two step process. First, a rough grinding (e.g. mesh 320) is done to remove the bulk of the silicon. Then an ultra fine grinding is performed to grind the last 20 µm. The ultra fine grind removes the deep mechanical damage from the rough step but does not remove the roughness of the substrate responsible for the grass formation.

As stated, the surface treatment step may be performed using a wet etching step or a dry etching step. In the case of a wet etching step, this step is preferably an immersion or spray or puddle etching of the substrate for a few minutes, preferably between 15s and 2min. The etching solution may be a solution comprising HNO₃, HF and H₂O or acetic acid, where the HNO₃ to HF ratio is preferably in the range 3:1 to 1:2 and the H₂O and the acetic acid content is preferably at least the same as the other constituents. A typical example is a solution consisting of 1 part HNO₃ (65% conc.) 1 part HF (49%) and 2 parts H₂O (or acetic acid) e.g. at 21°C [further referred to as "HNA" , B. Schwartz, H. Robbins, J. Electrochem. Soc. vol 123 (1976) 1903].

In the case of a dry etching step, said step is preferably performed using a CCP plasma or an ICP plasma (see definitions above). More preferably said dry etching is performed using an ICP or CCP plasma with a high degree of ion bombardment.

The degree of ion bombardment may be expressed in terms of the ion energy, which is preferably situated between 100eV and 1000eV for the purpose of the present invention. For a typical CCP type reactor, these levels of ion bombardment may be obtained by applying an absolute value of the Bias voltage VDC, or of the LF component of the applied voltages, of 200V or higher, more preferably 400 or higher.

For a typical ICP/TCP type reactor the absolute value of the Bias voltage (VDC), or of the LF component of the applied voltages, has to be 100 V or higher.

According to preferred embodiments, the dry-etch plasma used to perform the pre-cleaning contains one or more fluorine containing gases (e.g. SF6), possibly with one or more additive gases (e.g. Ar). According to preferred embodiments, the dry-etch plasma used to perform the pre-cleaning is an SF6 based CCP or ICP plasma for which the process time depends on the SiOx and Si removal rates of the process. This is typically between 1 and 10 minutes. 'SF6 based' means that the plasma takes place in a gas atmosphere consisting of SF6 and possibly additive gases such as Ar.

According to preferred embodiments, the surface treatment step is performed using a combination of the above mentioned wet and dry etching steps.

According to preferred embodiments, the step of performing deep reactive ion etching (DRIE) in order to achieve 3D vias is performed using a state of the art type of Bosch DRIE process (as described e.g. in patent document US-A-5501893), at an etch rate of approximately 2 µm/min. Applying a traditional Bosch DRIE etch process to the ground wafers without performing the preceding surface treatment step resulted in a surface full of grass because the used Bosch process is very selective towards silicon oxide (i.e. the native oxide) which is formed onto the surface of the extrusions remaining after grinding. Because these extrusions act as a micromask during the Bosch DRIE process silicon pillars are formed during the Bosch DRIE (referred to as "grass formation").

It is to be understood that although preferred embodiments, specific constructions and configurations, as well as materials, have been discussed herein for devices according to the present invention, various changes or modifications in form and detail may be made without departing from the scope of this invention as defined by the appended claims.

Example of process recipe settings used on a CCP reactor:

| Pressure | SF6 flow | Ar flow | RF power | Time |
|---|---|---|---|---|
| mbar | scm | sccm | W | s |
| 0.27 | 100 | 10 | 100 | 190 |

The process time can vary depending on the etch rate and the dimensions of the extrusions, and is based on the experiment results.

Example of process recipe settings used on a ICP reactor:

| Pressure | SF6 flow | CF4 flow | ICP Power | BIAS power | Time |
|---|---|---|---|---|---|
| mTorr | scm | sccm | W | W | s |
| 5 | 100 | 180 | 1500 | 200 | 60 |

The process time can vary depending on the etch rate and the dimensions of the extrusions, and is based on the experiment results.

Example of process recipe settings used on a DSiE for a Bosch type process approach.

| Priority | Valve position | SF6 flow | CF4 flow | ICP Power | BIAS power | BIAS on pulse | BIAS off pulse | step time |
|---|---|---|---|---|---|---|---|---|
| | % | scm | sccm | W | W | % | % | s |
| 1 | 100 | 0 | 350 | 1500 | 200 | 100 | 0 | 2 |
| 2 | 100 | 350 | 0 | 1500 | 200 | 100 | 0 | 5 |

The total process time has to be defined based on experiment results.

Example of the combination of the above mentioned wet and dry etching steps : after the grinding, a plasma as in paragraph [0036] with a process time of only 1 minute is applied, followed by a 2 minutes HNA wet etching, again followed by a DI water rinse and an N2 dry step.

## Claims

1. A method for producing 3D structures in a semiconductor substrate using Deep Reactive Ion Etching (DRIE), comprising at least the steps of:
- providing a substrate (1),
- grinding the backside of the substrate in order to achieve a thinned substrate, wherein extrusions (2) and native oxides (3) are left after said grinding step,
- performing a surface treatment selected from the group consisting of a wet etching step and a dry etching step in order to remove at least said native oxides (3) and extrusions (2) on the surface of said backside of the substrate which are causes for the grass formation during subsequent etching,
- performing deep reactive ion etching in order to achieve 3D vias.

2. The method according to claim 1 wherein the substrate (1) is a silicon wafer, more preferably a processed silicon wafer comprising active devices.

3. The method according to claim 1 or 2, wherein the surface treatment step is a wet etching step performed by immersion, spray or puddle etching of the substrate in a solution comprising HNO₃, HF and H₂O or acetic acid, where the HNO₃ (65% conc.) to HF (49% conc.) ratio is preferably in the range 3:1 to 1:2 and the H₂O and the acetic acid content is preferably at least the same of the other constituents.

4. The method according to claim 3, wherein said solution consists of 1 part HNO₃ (65% conc.), 1part HF (49%) and 2 parts H₂O.

5. The method according to claim 3 or 4, wherein the wet etching step is performed during a time interval of between 15 seconds and 2 minutes.

6. The method according to claim 1 wherein the surface treatment step is a dry etching step performed using a CCP plasma or an ICP plasma.

7. The method according to claim 6 wherein the surface treatment step is a dry etching step performed using an ICP or CCP plasma containing one or more fluorine containing gases (e.g. SF₆), with optionally one or more additive gases (e.g. Ar).

8. The method according to claim 6 wherein the surface treatment step is a dry etching step performed using a CCP type reactor wherein the absolute value of the Bias voltage or of the LF component of the applied voltages is 200 V or higher.

9. The method according to claim 6 wherein the surface treatment step is a dry etching step performed using an ICP type reactor wherein the absolute value of the Bias voltage or of the LF component of the applied voltages, is 100 V or higher.

10. Use of the method according to claims 1 to 9 in DRIE etching of deep silicon structures (e.g. vias) in 3D integration of silicon wafers.
